Europäisches Patentamt

**European Patent Office**

**Office européen des brevets**

(19)

(11) Publication number: **0 141 571**
**A2**

# EUROPEAN PATENT APPLICATION

(21) Application number: **84307075.6**

(22) Date of filing: **16.10.84**

(51) Int. Cl.⁴: **H 01 L 21/00**
**H 01 L 21/82, H 01 L 21/28**

(30) Priority: **20.10.83 US 543955**

(43) Date of publication of application:
**15.05.85 Bulletin 85/20**

(84) Designated Contracting States:
**DE FR GB**

(71) Applicant: **ZYTREX CORPORATION**
**224 North Wolfe Road**
**Sunnyvale California 94086(US)**

(72) Inventor: **Wanlass, Frank Marion**
**21498 Meteor Drive**
**Cupertino california 95014(US)**

(74) Representative: **Horton, Andrew Robert Grant et al,**
**BOULT, WADE & TENNANT 27 Furnival Street**
**London, EC4A 1PQ(GB)**

(54) High performance two layer metal cmos process using a reduced number of masks.

(57) A process, is disclosed for forming self aligned metal gate CMOS devices with guard rings isolating the active devices from each other and comprising only three mask steps prior to the contact mask where etching is done to contact junctions. The process is specifically defined for use with two layers of metal; the first metal layer provides source and drain contacts and spans the gate, the second metal layer providing device intraconnections. The three masking steps that are provided are a P well mask for defining the region in which N type devices are to be defined; a mask for defining the N type devices and guard rings; and a boron mask for defining the devices of the opposite type. (The sequence may, of course, be used to first define an N well, followed by diffusion of P type and then N type devices.) By the use of this sequence of masks, the active devices may be accurately placed, the gates are self aligned and by the use in combination therewith of low temperature controlled processing, very fine channel lengths are achieved. Further, the major surface of the device is very flat having no large steps either in the field areas between the devices or in the areas of the active devices.

FIG. —IH

-1-

" HIGH PERFORMANCE TWO LAYER METAL CMOS
PROCESS USING A REDUCED NUMBER OF MASKS "

This invention is related to the area of semiconductor device processing and specifically to a fast two layer metal CMOS process using a reduced number of masks.

CMOS gate delays can be greatly reduced, by using very short channel lengths and very thin gate oxides, to the point that signal delays in a CMOS integrated circuit will be dominated by chip intraconnection RC time constants. Just as in high speed bipolar circuits, in order not to have this limitation, it becomes necessary to use two layers of metal for CMOS chip intraconnection.

There are presently two types of processes established to manufacture CMOS chips called "metal gate" and "silicon gate". Extra masking and process steps can be added to either of these basic processes to make a two layer metal circuit. However, CMOS processing is fairly complex already; with the addition of more steps, cost and yield of two layer metal chips can be expected to suffer, specifically for very fine line high performance circuits.

This invention relates to a new two layer metal CMOS process designed not as an add on to existing processes, but designed specifically around the goal of having a high speed two layer metal process that is as simple as possible. The result is a complete process flow that has only eight masking steps including pad mask.

0141571

Since our new process is a very high speed "scaled" process, it's closest competitor will be some of the recent silicon gate processes as adapted for two layer metal. Therefore, before describing our process in detail, let us review the steps for such a silicon gate process.

The following outline of steps might be typical:

MASK 1
1. Grow oxide on N type substrate.
2. Use well mask to open oxide for P minus implant.
3. Implant P minus, grow oxide over well, and diffuse well.
4. Strip all oxide, grow new thin oxide, and deposit nitride.

MASK 2
5. Use active mask to protect nitride with resist where transistors and diffusions will later be.
6. Plasma etch nitride with resist as mask, leave on resist.

MASK 3
7. Use well mask again to protect against another P minus implant.
8. Implant P minus, (Active regions and non-well regions are protected). This implant raises the field threshold of the N channel transistors in the well.
9. Strip resist and grow field oxide to about 1 micron.
10. Strip nitride and grow gate oxide in active areas.
11. Implant gate with P minus to control thresholds; no mask is required.
12. Deposit polysilicon and dope with phosphorus.

MASK 4
13. Use gate mask to define polysilicon, etch polysilicon and clean off resist.

MASK 5  14.    Use N-Channel mask to define which active areas will be NMOS, and implant N plus with resist as a mask to form sources and drains.

15.    Strip resist and drive junctions.

MASK 6  16.    Use P minus channel mask to define which active areas will be PMOS, and implant P plus with resist as a mask to form sources and drains.

17.    Strip resist and drive junctions.

18.    Deposit oxide over entire surface.

MASK 7  19.    Use first contact mask to etch openings thru oxide to junctions and to polysilicon, strip resist.

MASK 8  20.    Deposit metal over surface and etch with first metal mask defining pattern, strip resist.

21.    Deposit oxide or other dielectric over first level metal.

MASK 9  22.    Use second contact mask to etch via holes thru dielectric to first level metal, strip resist.

MASK 10  23.    Deposit metal and etch with second metal mask defining pattern, strip resist.

24.    Deposit scratch protection over entire surface.

MASK 11  24.    Use pad mask to etch openings thru oxide to bonding positions on second metal.

In addition, an extra mask is sometimes used to control P channel field inversion with a selective N type implant before the field oxide is grown.

Besides all the steps involved, there are certain weaknesses in this process when trying to make scaled geometry devices:

(a) To achieve scaling, the gate mask has to have a very short gate length of less than two microns. Trying to carefully etch this fine a line in polysilicon that is traversing a field oxide step of about 7,000 A is difficult.

(b) Scaled transistors need gate thicknesses reduced to 150 A. With phosphorus doped polysilicon as the gate electrode, it is very hard to keep phosphorus from diffusing through the gate dielectric and into the channel region.

(c) By the time the second level metal is deposited there are many up and down steps on the surface; the metal has to reliably traverse field oxide, poly, first metal and contacts.

Therefore, it is the object of this invention to reduce the number of masks required for two layer metal CMOS. Specifically, we will eliminate the active, gate and field threshold masks.

A second objective is to provide a more planar surface for critical gate length delineations, and for better intraconnect step coverage.

A third objective is to have a very high performance "scaled" CMOS process that allows (1) gate lengths of less than 2 µcrons, 2) gate dielectric thicknesses of less than 150A, and 3) is self aligned for gate to drain capacitance reduction.

A fourth objective is to have a process that is free of field inversion for both P channel and N channel devices even though no field implants are used.

These and other objectives are accomplished by the development of a process for forming self aligned metal gate CMOS devices with guard rings isolating the active devices from each other and comprising only three mask steps prior to the first contact mask where etching is done to contact junctions, saving three masks up to this point.  This sequence would not normally be used for a single level metal process because there is not a step to grow thick field oxide; such thick oxide is needed to reduce the capacitance between long metal runs and the substrate.  However, the inventor here has discovered that if the invented process is used only for two layer metal, in which there is a rather thick dielectric between metal 1 and metal 2, then, by using metal 2 for long intraconnects and using metal 1 for short distances, the process sequence is practical.

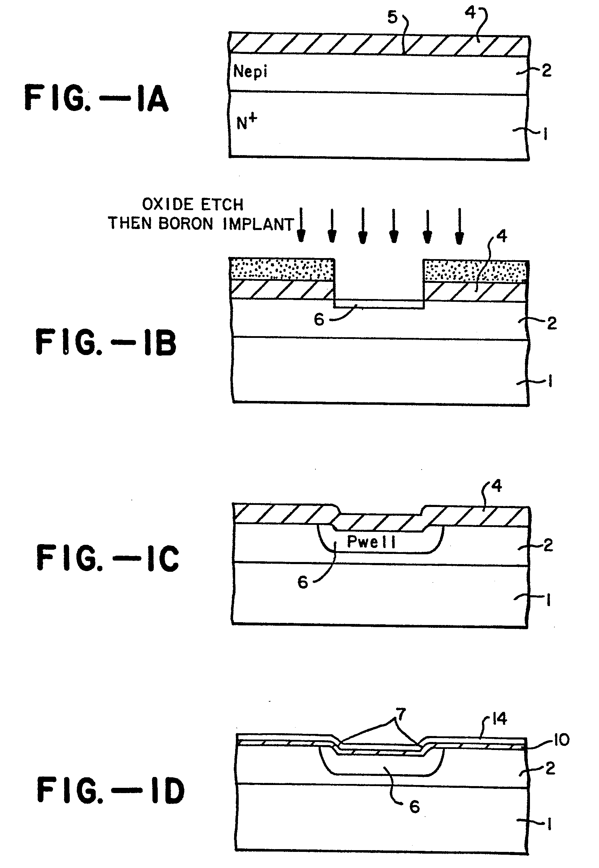

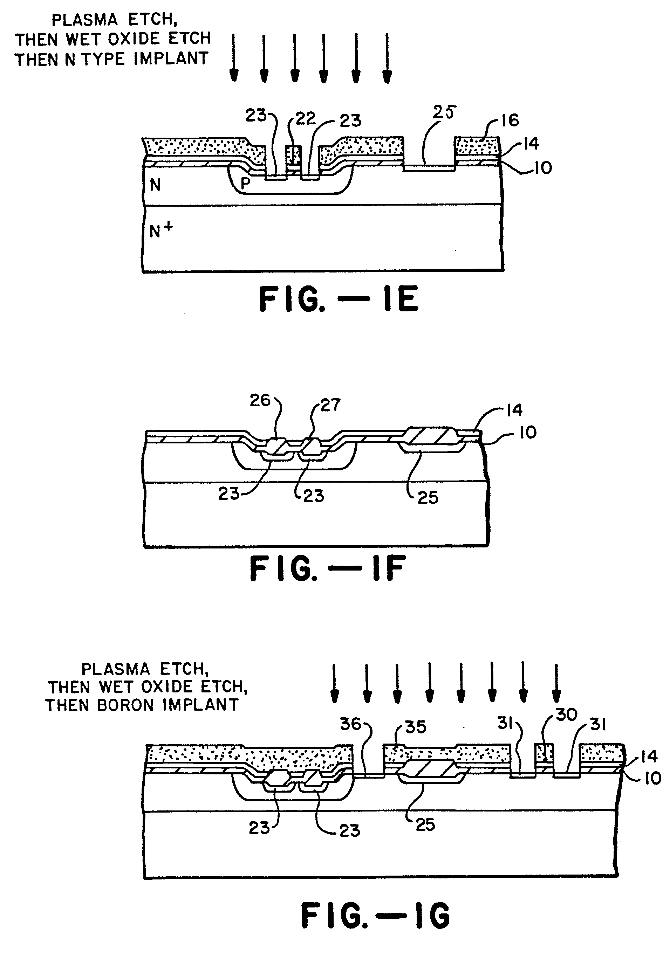

In disclosing this invention, it can be best understood by reference to Figure 1 in which Figure 1A shows the starting material;

Figures 1B - 1H show the results of the sequence of steps which is followed;

Figure 2 is a plan view of a completed device showing the guard banded structure of the invention.

The process according to the present invention is initiated using a substrate 1 comprising material of either 1-0-0 or 1-1-1 orientation, and having an epi layer 2 of 1-2 ohm-cm resistivity and 6-10 microns in thickness grown thereon. In the preferred embodiment which will be described in this application, an N type substrate material with an N epi layer is utilized.  The process is, of course, reversible to use P type substrate material.

Epi is preferred, but the process can also be run on non-epi material of 1-2 ohm-cm.

As an initial step after growth of the epi layer 1, an oxide layer 4 preferably of about 3,000A thickness is grown on the entire upper surface 5 of the substrate.  At this point the first mask operation is performed to define the P wells where N channel devices will eventually be defined. This masking step is followed by an etch through the oxide to define the location where the wells will be formed as shown in Fig. 1B. The P well 6 is established preferably using a boron implant, followed by a long, high temperature drive in an oxidizing ambient. The wells are preferably of a final depth of about 6 microns so that they extend partially but not entirely through the depth of the epi layer 2.

After the P well 6 (Figure 1C) is driven and oxidized, the oxide layer 4 is stripped off. It should be noted that after this stripping there will be an outline on the surface of the wafer defining for future alignment purposes the outline of the area of the boron well implant. These outlines are visible as very shallow steps 7 in the surface 5 of the epi layer.

As a next step, a new very thin oxide layer 10, of about 150A to 200A, is grown over the entire surface of the epi layer 2. This constitutes a significant departure from the direction which previously described CMOS processing has followed, in which a thin oxide is grown only over active areas with thick oxide being defined elsewhere. This thin oxide 10 (Figure 1D) will be left in place in gate regions of finished devices.

As a next step, a thin silicon nitride layer 14 of about 200A to 400A, is deposited. This layer is also left in place in the finished device gate structure. Next, the second masking step is carried out. That is, a photoresist mask 16 is put in place (Figure 1E), allowing for a plasma etch of the silicon nitride and a wet etch of the oxide to define where N diffusions will go, with the area 22 defining the eventual gate region. It should be noted that because of the processing steps taken to this point, the surface of the entire device has remained quite flat compared to known processes, providing easier fine line masking such as required to define area 22 (this will be less than two microns). A further advantage of this process is that the layers of oxide 10 and silicon nitride 14 are very thin, allowing good etch definition without undercutting. In contrast, in polysilicon gate processes, the gate etching must be carried out through layers 3,000 to 5,000A thick, which is about 10 times as thick as the layers used here.

As a next step, using the now defined N openings, and keeping the photoresist layer 16 as a mask, a phosphorus implant is carried out establishing the sources and drains 23. This is a major step saving because the photoresist 16 can be used both as an etch mask to define the junctions 23, and gate region 22; it is left in place, and can also be later used as an implant mask. It is important to note that this procedure specifically keeps phosphorus contamination out of the gate dielectric, which allows the possible use of very thin gate dielectrics, without fear of contamination diffusing thru the dielectric into the underlying channel. Channel stoppers 25 for P channel devices may be simultaneously defined with N channel devices, as shown in Figure 1E.

After the phosphorus implant, the photoresist layer 16 is stripped off. In an oxygen ambient there is now a very controlled heating step to minimize lateral diffusion of the source and drain regions 23. As a result of this step, oxide regions 26, 27 and 28 of about 1,000A are also grown over the source, drain and channel stop regions, the silicon nitride 14 effectively acting as an oxidation mask for the remainder of the surface, as shown in Figure 1F.

The next, and only the third mask is the boron masking step which is used to define the adjacent P channel device having source, drain and gate regions 31 and 30.

This is also a narrow gate region 30 device, (less than 2 microns) which can be masked and etched with good definition because we are working on a surface with step heights of less than 1000A.  Just as with the N channel device, the photoresist 35 is used to mask against plasma etch, wet etch and boron implant, keeping contamination out of gate regions.  As shown in Figure 1G channel stoppers 36 for N channel devices are simultaneously defined.

Low energy implants are necessary for both boron and phosphorus implants to insure that no ions penetrate the resist into the gate regions.  Phosphorus is preferably implanted at a level of $2x10^{15}$/cm at 60 kev; and Boron at $1x10^{15}$/cm at 30 kev.

Now all the photoresist is removed and another oxidation and diffusion is carefully carried out.  This oxidation is done for a somewhat longer time to grow a thicker oxide over the N and P diffusions of about 2000A.  Since oxide growth rate decreases as it gets thicker, the thickness over the junctions 31 will be about the same as that over junctions 23, and likewise over the channel stop regions.  It is not desirable to grow oxide much thicker than about 2000A, because oxide growth encroaches on silicon laterally as well as vertically, and if a normal field thickness of 10,000A (1 micron) were attempted this would be too much encroachment on our very short gate regions 22 and 30.

We have just described the phosphorus being implanted first and the boron second; however, this sequence can be reversed with minor changes in oxidation times.

The critical thing to note is that the source, drains and gates of the active devices and channel stoppers between active devices, have been defined with only three masking steps.  The devices are now ready for the essential two layers of metal interconnections.

Next the first contact mask (Cl) is used to define and etch oxide where the first metal (Ml) layer will connect N or P diffusions.  The resist is now cleaned off and first metal is deposited.  This metal 46 is patterned to contact the source and drain junctions and span the gate regions as shown in Figure 1H.

This process is self aligned because the oxide over the junctions is about 5 times thicker than the oxide-nitride sandwich over the channels (2000A vs 400A).

As M1 carries a signal from a P channel transister to an N channel transistor it will traverse channel stop regions 25 and 36 that are covered with about 2000A of oxide, and will traverse thin dielectric regions 47 of 400A thickness.  To minimize stray capacitance of M1 traces, even though they might not be very long, it is important in the layout to have channel stop diffusions under M1 intraconnects wherever possible.

After M1 is etched and the resist cleaned off, a dielectric layer 48 of about 8000A is deposited.  This can be oxide, nitride, a polymer, or a combination.  Now the second contact mask (C2) is used to define and etch vias 49 through this dielectric in those places where it is desired that second metal (M2) should connect M1.  The resist is cleaned off and M2 is deposited, patterned and etched.  This metal is usually made thicker than the first metal (10,000A vs 5,000A) to help ensure reliable traversing of M1 steps by M2.

The resist is cleaned off, another scratch protection dielectric is deposited and openings are defined and etched using the pad mask, bringing us to a total of eight masking steps.

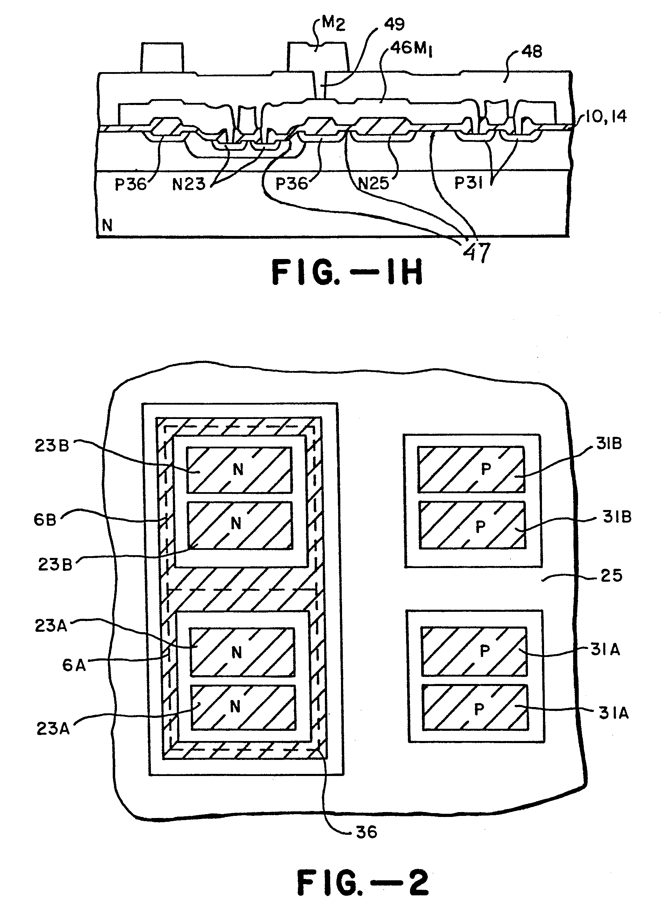

The simplicity of this process relative to processes known in the prior art can be further appreciated by a study of Figure 2, a plan view of a partially completed device corresponding to just after the process step of Figure 1G.  As can be seen, adjacent P-wells 6A and 6B for adjacent N-

-10-                                    **0141571**

channel devices 23A and 23B have been formed. Simultaneously with the formation by implantation of source and drain regions 23A and guard bands 25 for adjacent P channel devices 31A and 31B are implanted.

Later in the process when P sources and drains 31A and 31B are established, the guard bands 36 around the N channel devices are implanted. The result is the efficient use of process steps with guard bands encircling adjacent channel devices of both N and P types, providing high field thresholds in a scaled, self-aligned dual metal gate process.

Most all other known processes use two additional masks to suppress field inversion. However, according to this process, active devices and guard bands are put in place simultaneously. Further, by using an eight mask process, which nevertheless gives two layers of metal, long runs of metal are far removed from these active devices.

It is yet a further advantage of this invention and is important to note that the gate regions get no doping, boron or phosphorus, and are kept clean so that there is no possibility of doping into the channel. Following the implants into the source and drain regions, diffusion is carried out at reduced temperatures so that short channels can be achieved.

These and other advantages are achieved by the subject invention whose scope is not limited by the above description but by the appended claims.

0141571

CLAIMS:

1. A process for defining CMOS semiconductor devices in a substrate of a first conductivity type comprising a first masking step for diffusing a well of a second conductivity type in said substrate; a second masking step for both defining and diffusing the sources and drains of devices of a first conductivity type in said well simultaneously with the diffusion of first conductivity-type guard bands in said substrate surrounding said devices in said wells whereby device isolation is established; a third masking step for both defining and diffusing sources and drains of devices of a second conductivity type in said substrate simultaneously with the diffusion of guard bands of a second conductivity type; whereby NMOS and PMOS active devices are defined by only three masking steps prior to any metal mask steps.

2. A process as claimed in Claim 1 comprising a step between said first and second masking steps of growing a thin oxide layer of about 200Å thickness to be used as a gate oxide for said devices, said oxide layer remaining in place for use as said gate oxide throughout the processing of said device.

3. A process as claimed in Claim 2 further comprising depositing a thin layer of silicon nitride over said silicon oxide layer prior to said second masking step.

4. A process as claimed in Claim 2 wherein said second and third mask steps utilize the same mask layer to define the source and drain of said active devices and to establish the source and drain by appropriate impurities, and protect the gate region of said devices against infusion of impurities of said active devices, whereby short channel active devices are defined.

5. A process for forming a CMOS semiconductor device comprising the steps of:

forming within a first semiconductor region of a first conductivity type a well region of a second conductivity type opposite said first conductivity type;

forming a first thin insulation layer on the surface of said first semiconductor region, said insulating layer remaining in place on the surface of said device;

patterning said insulating layer to define first regions comprising sources and drains of active devices of said first conductivity type and guard bands surrounding areas wherein active devices of said second conductivity type will be established;

introducing a dopant of said first conductivity type into said first regions comprising said sources, drain and guard bands;

patterning said insulating layer to define second regions comprising sources and drains of active devices of said second conductivity type and guard bands of said second conductivity type surrounding the active devices of said first conductivity type;

introducing dopants of said second conductivity type into said defined second regions, each of said active devices being separated by field regions; and

establishing a second insulating layer over all of said device and forming a conductive layer on the surface of said CMOS transistor to simultaneously establich a gate electrode and contacts to said source and drain regions of said active devices whereby a self-aligned metal gate MOS device is defined.

6. The process of Claim 5 further comprising the steps of depositing a thick third insulating layer over all of said device whereby metal intraconnections of said active devices are electrically isolated from the field regions between said active devices.

7. The process of Claim 5 further comprising forming vias in said third insulation layer to expose selected portions of said electrodes; and

forming a conductive interconnect layer on said second insulation layer, said conductive interconnect layer being formed in said vias so as to contact selected portions of said electrodes, long metal intraconnections being defined in this second layer.

8. The process of Claim 5 wherein the steps of introducing dopants further comprises the step of controllably heating said semiconductor device to diffuse said dopants within said region while controlling the channel length of said active device and regrowing the oxide over said region to maintain the relatively level topology of the device.

9. The process as defined in Claim 5 wherein said first conductivity type is N and said second conductivity type is P.

10. The process as defined in Claim 5 wherein said first conductivity type is P and said second conductivity type is N.

11. The process as defined in Claim 5 wherein said step of forming a first insulation layer is limited to formation of an oxide insulation layer of about 200$\overset{\circ}{A}$ thickness, said insulation layer remaining in place over the channel of said device throughout the processing of said device.

12. The process as defined in Claim 6 wherein said first insulating layer comprises a material selected from the group of materials consisting of oxides of silicon and silicon nitride.

13. The process as defined in Claim 5 wherein said first insulating layer is formed first by establishing a film of an oxide of silicon and second by depositing a film of silicon nitride, to a total thickness of no more than about 400Å.

14. The device of Claim 6 wherein said first insulation layer comprises silicon nitride over an oxide of silicon, said silicon nitride retarding the growth of the insulating layers over said substrate during processing thereof whereby a level topology of said device is maintained.

15. A monolithic CMOS device comprising,

a semiconductor substrate of a first conductivity type;

a plurality of body regions formed within said first semiconductor region, each said body region being of a second conductivity type opposite said first conductivity type, and separated from adjacent body regions by field regions of said first conductivity type;

a first insulation layer formed on the surface of said transistor of a thickness of about 200Å,

active devices comprising sources and drains of said first conductivity type formed in each of said wells,

guard bands of said second conductivity type surrounding said devices of first conductivity type, at least one of said guard bands of second conductivity type lying between adjacent active devices of said first conductivity type, and

a second thicker grown layer of insulation overlying said field regions between said adjacent active devices whereby short-channel length devices of the same conductivity type can be positioned closely adjacent on said substrate.

16. A device as claimed in Claim 15 further comprising a first metal layer over said thicker insulation for defining source and drain contacts and to span the gate region, a third, thick dielectric layer over said first metal layer, and a second metal layer over said dielectric patterned to form device intraconnections with minimal capacitance.

1/3

**FIG.—IA**

5   4

Nepi ─2

N⁺ ─1

OXIDE ETCH
THEN BORON IMPLANT ↓ ↓ ↓ ↓ ↓ ↓

**FIG.—IB**

4

6 ─2

─1

**FIG.—IC**

4

Pwell ─2

6 ─1

**FIG.—ID**

7   14

10

6 ─2

─1

PLASMA ETCH,
THEN WET OXIDE ETCH
THEN N TYPE IMPLANT

FIG. — IE

FIG. — IF

PLASMA ETCH,
THEN WET OXIDE ETCH,
THEN BORON IMPLANT

FIG. — IG

0141571

FIG. —IH

FIG. —2